# FASCICULE DE BREVET EUROPEEN

(11) **EP 0 573 326 B1**
(45) Date de publication et mention de la délivrance du brevet: **20.12.1995**
(21) Numéro de dépôt: 93401303.8
(22) Date de dépôt: 19.05.1993
(51) Int. Cl.: H03K 3/356, H03K 3/037, H03K 3/3562

(54) **Bascule bistable à commande de réinitialisation**
Bistabile Kippschaltung mit Reinitialisierungssteuerung
Bistable latch with reinitialisation control

(30) Priorité: 05.06.1992 FR 9206871
(43) Date de publication de la demande: 08.12.1993
(73) Titulaire: SGS-THOMSON MICROELECTRONICS S.A., 94250 Gentilly (FR)
(72) Inventeur: Menut, Patrick Bruno, F-38130 Echirolles (FR)
(74) Mandataire: Schmit, Christian Norbert Marie

(56) Documents cités:
- EP-A- 0 273 082
- EP-A- 0 472 426
- PATENT ABSTRACTS OF JAPAN vol. 10, no. 283 (E-440)(2339) 26 Septembre 1986;& JP-A-61101113
- PATENT ABSTRACTS OF JAPAN vol. 10, no. 99 (E-396)(2156) 16 Avril 1986;& JP-A-60241320

## Description

La présente invention concerne une bascule bistable à commande de réinitialisation.

L'invention s'applique notamment à une bascule à retard (bascule D) réalisée en technologie CMOS (métal-oxyde semi-conducteur complémentaire). Une telle bascule comporte habituellement un étage maître et un étage esclave cadencés par des signaux d'horloge décalés.

Le document JP-A-61-101113 propose une bascule à retard à commande de réinitialisation selon le préambule de la revendication 1, comportant deux cellules de mémorisation, chacune formée de deux inverseurs, et montées en parallèle sur une ligne reliant l'entrée de la bascule à sa sortie.

Chaque étage est constitué par une cellule de mémorisation comportant deux portes logiques montées en parallèle, l'une de ces deux portes étant montée en rétroaction par rapport à l'autre pour assurer la fonction de mémorisation. Pour compenser les courants de fuite et assurer ainsi la stabilité de l'information mémorisée, la porte logique montée en rétroaction est réalisée à partir de transistors MOS à canal résistif, c'est-à-dire comportant un canal et une grille relativement longs. Ces transistors à canal résistif occupent une surface importante sur un circuit intégré, et on cherche donc en général à réduire leur nombre pour obtenir les fonctionnalités recherchées avec un circuit compact.

La réinitialisation de la bascule D doit s'opérer simultanément sur les deux étages à partir d'un même signal de commande. Classiquement, l'étage maître comporte une porte NON ET montée en rétroaction par rapport à une porte inverseuse, et la réinitialisation de cet étage maître est assurée par l'une des entrées de cette porte NON ET recevant le signal de commande de réinitialisation actif à l'état 0. Cette porte NON ET nécessite quatre transistors MOS à canal résistif et est donc relativement encombrante en terme de surface de circuit intégré. En outre, il est nécessaire de compléter cette porte NON ET par d'autes éléments logiques destinés à éviter les conflits d'écriture à l'entrée de la porte inverseuse.

Au vu de ce qui précède, le but de la présente invention est de proposer une bascule bistable, notamment du type à retard, occupant une surface réduite, afin d'augmenter la densité d'implantation d'un circuit intégré comprenant des bascules de ce type.

Suivant l'invention, ce bus est atteint par une bascule bistable, formant une bascule à retard, comprenant au moins une borne d'entrée pour recevoir un signal d'entrée, une borne de sortie, une borne de commande de réinitialisation, un étage maître et un étage esclave,
- la borne d'entrée étant reliée aux grilles de deux transistors à effet de champ de type respectivement P et N agencés pour former un signal d'écriture par inversion du signal d'entrée (D),
- l'étage maître comprenant une cellule de mémorisation, cette cellule de mémorisation comprenant :
- un premier inverseur ayant une entrée recevant le signal d'écriture et une sortie,
- un second inverseur ayant une entrée reliée à la sortie du premier inverseur, et une sortie reliée à l'entrée du premier inverseur,
- la bascule comprenant en outre un premier et un deuxième transistors à effet de champ de types différents, dont les grilles sont reliées à la borne de commande de réinitialisation, le canal du premier transistor étant monté entre l'entrée du premier inverseur et une première borne de référence, le canal du deuxième transistor étant monté en série avec les canaux des deux transistors reliés à la borne d'entrée, la source du transistor de type P relié à la borne d'entrée étant reliée à la première borne de référence, et la source du transistor de type N relié à la borne d'entrée ou la source du deuxième transistor étant reliée à une seconde borne de référence,

caractérisée en ce que
- l'entrée du premier inverseur est reliée à un premier interrupteur commandé par des premiers signaux d'horloge (HM, NHM), ce premier interrupteur étant placé entre le drain du transistor de type P relié à la borne d'entrée et l'entrée du premier inverseur,
- l'étage esclave comprend
- une porte NON ET ayant une première entrée reliée à la sortie du premier inverseur par l'intermédiaire d'un second interrupteur commandé par des seconds signaux d'horloge (HE, NHE) décalés temporellement par rapport aux premiers signaux d'horloge (HM, NHM), une seconde entrée reliée à la borne de commande de réinitialisation et une sortie reliée à l'entrée d'un troisième inverseur, dont la sortie est reliée à la borne de sortie,
- un quatrième inverseur ayant une entrée reliée à la sortie de la porte NON ET et une sortie reliée à la première entrée de la porte NON ET.

Ainsi, la porte logique montée en rétroaction dans la cellule de mémorisation est un inverseur qui ne nécessite typiquement que deux transistors à canal résistif. La bascule a donc un encombrement en surface inférieur à celui des bascules classiques. La fonction de réinitialisation est réalisée par les deux commutateurs, le premier imposant la réinitalisation de la cellule tandis que le second empêche les conflits de signaux à l'entrée du premier inverseur.

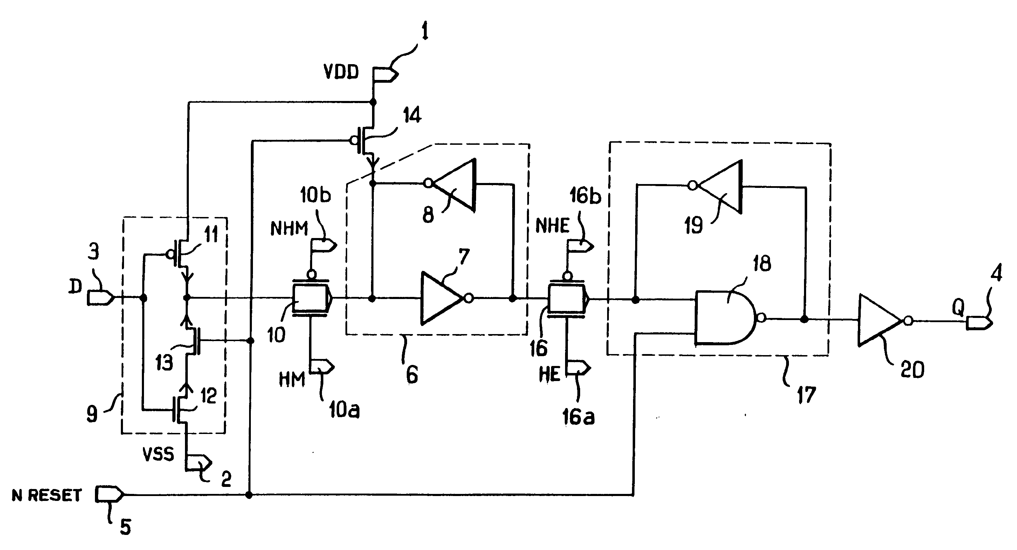

D'autres particularités et avantages de la présente invention apparaîtront dans la description détaillée ci-après d'un exemple de réalisation préféré et non limitatif, lue conjointement au dessin annexé dans lequel l'unique figure représente un schéma électrique d'une bascule selon l'invention.

La figure illustre une bascule à retard (bascule D) à commande de réinitialisation réalisée selon l'invention. Les entrées et sorties de cette bascule sont les suivantes :
- borne de référence 1 recevant la tension d'alimentation positive VDD du circuit représentative de l'état logique 1 ;
- borne de référence 2 recevant la tension de la masse VSS représentative de l'état logique 0 ;
- borne d'entrée 3 recevant le signal binaire d'entrée D de la bascule ;
- borne de sortie 4 délivrant le signal binaire de sortie Q de la bascule ;
- borne de commande de réinitialisation 5 recevant un signal binaire de réinitialisation NRESET actif à l'état logique 0 ;
- bornes d'horloge maître 10a, 10b recevant respectivement un signal d'horloge maître HM et l'inverse logique NHM de ce signal d'horloge maître ; et
- bornes d'horloge esclave 16a, 16b recevant respectivement un signal d'horloge esclave HE et l'inverse logique NHE de ce signal d'horloge esclave.

La bascule comprend un étage maître 6 et un étage esclave 17 constitués chacun par une cellule de mémorisation. L'entrée de l'étage maître 6 est reliée à la borne d'entrée 3 de la bascule par l'intermédiaire d'une porte 9 et d'un interrupteur 10. La sortie de l'étage maître 6 est reliée à l'entrée de l'étage esclave 17 par l'intermédiaire d'un interrupteur 16. La sortie de l'étage esclave 17 est reliée à la borne de sortie 4 de la bascule par l'intermédiaire d'un inverseur 20.

La porte 9, dont la structure sera détaillée plus loin, produit un signal d'écriture qui est l'inverse logique du signal d'entrée D et, dans certaines conditions, transmet ce signal d'écriture vers l'interrupteur 10. L'interrupteur 10 est constitué de façon classique par un transistor MOS à canal n dont la grille reçoit le signal d'horloge maître HM et par un transistor MOS à canal p dont la grille reçoit le signal d'horloge maître inversé NHM, ces deux transistors étant montés avec leurs canaux en parallèle. L'interrupteur 10 est donc ouvert lorsque HM = 0 et fermé lorsque HM = 1.

La cellule de mémorisation 6 formant l'étage maître comprend un premier inverseur 7 dont l'entrée est reliée à l'interrupteur 10 et un second inverseur 8 dont l'entrée est reliée à la sortie du premier inverseur 7 et dont la sortie est reliée à l'entrée du premier inverseur 7. Comme expliqué précédemment, le second inverseur 8 monté en rétroaction est constitué de façon classique par des transistors MOS à canal résistif pour compenser les courants de fuite dans la cellule 6.

La sortie du premier inverseur 7 est en outre reliée à l'interrupteur 16 qui est du même type que l'interrupteur 10 avec un transistor MOS à canal n dont la grille reçoit le signal d'horloge esclave HE et un transistor MOS à canal p dont la grille reçoit le signal d'horloge esclave inversé NHE. L'interrupteur 16 est donc ouvert lorsque HE = 0 et fermé lorsque HE = 1.

L'étage esclave 17 est constitué par une cellule de mémorisation comprenant classiquement une porte NON ET 18 ayant une première entrée reliée à l'interrupteur 16, une seconde entrée reliée à la borne de commande de réinitialisation 5 et une sortie reliée à la borne de sortie 4 de la bascule par l'intermédiaire de l'inverseur 20. L'étage esclave 17 comprend en outre un inverseur 19 monté en rétroaction par rapport à la porte NON ET 18 avec son entrée reliée à la sortie de la porte NON ET 18 et sa sortie reliée à la première entrée de la porte NON ET 18. L'inverseur 19 est constitué par des transistors MOS à canal résistif pour compenser les courants de fuite dans l'étage esclave 17.

Les signaux d'horloge maître et esclave HM, HE sont des signaux de même fréquence, décalés temporellement pour assurer le fonctionnement en maître-esclave des deux étages 6, 17, et non recouvrants à l'état haut pour éviter tout problème de transparence de la bascule. Typiquement, le signal d'horloge maître HM peut avoir un rapport cyclique de 0,5 et le signal d'horloge esclave HE peut être l'inverse logique de ce signal HM.

La réinitialisation de l'étage esclave 17 est effectuée par l'intermédiaire de la seconde entrée de la porte NON ET 18. Lorsque le signal de réinitialisation est actif (NRESET = 0), l'étage esclave 17 est à l'état 1 sur sa sortie et le signal de sortie Q est réinitialisé à l'état 0. Cet état de l'étage esclave 17 se maintient jusqu'à ce que la commande de réinitialisation disparaisse et qu'un signal à l'état 1 parvienne à la première entrée de la porte NON ET 18 par l'intermédiaire de l'interrupteur 16.

Pour la réinitialisation simultanée de l'étage maître 6, la bascule comprend un premier commutateur 14 constitué, dans l'exemple représenté, par un transistor à effet de champ MOS à canal p 14 dont la grille est reliée à la borne de commande de réinitialisation 5. Le canal du transistor 14 est monté entre la borne de référence 1 à la tension VDD et l'entrée du premier inverseur 7 de l'étage maître 6. Lorsque NRESET est à l'état actif, le commutateur 14 est fermé et l'état logique 1 est imposé à l'entrée de l'inverseur 7, de sorte que la sortie de l'étage maître 6 est réinitialisée à l'état 0.

La bascule comprend en outre un second commutateur 13 disposé pour empêcher que l'entrée du premier inverseur 7 puisse recevoir un signal d'écriture à l'état logique 0 inverse de celui imposé par le premier commutateur 14 lorsque le signal de réinitialisation NRESET est actif. Dans l'exemple représenté, le second commutateur 13 est un transistor à effet de champ MOS à canal n inclus dans la porte 9, dont la grille est reliée à la borne de commande de réinitialisation 5.

La porte 9 comprend, outre le second commutateur 13, deux transistors à effet de champ MOS de polarités différentes 11, 12 dont les grilles respectives sont reliées à la borne d'entrée 3 de la bascule. Le transistor MOS à canal p 11 a sa source reliée à la borne de référence 1 à la tension VDD et son drain relié à l'interrupteur 10. Le transistor MOS à canal n 12 a son canal monté en série avec celui du transistor 13 formant le second commutateur entre la borne de référence 2 à la tension VSS et l'interrupteur 10. Dans l'exemple représenté, le transistor à canal n 12 a son drain relié à la borne de référence 2 et sa source reliée au drain du transistor-commutateur 13 dont la source est reliée à l'interrupteur 10. On observe qu'en faisant abstraction du commutateur 13, la porte 9 a la structure classique d'un inverseur CMOS. Le signal d'écriture pouvant être adressé à l'entrée de l'étage maître 6 lorsque l'interrupteur 10 est fermé est l'inverse du signal d'entrée D. Toutefois, lors d'une commande de réinitialisation, le commutateur 13 est ouvert (NRESET = 0), ce qui empêche la transmission d'un signal d'écriture à l'état 0 qui pourrait créer un conflit de données à l'entrée de l'inverseur 7 et occasionner un court-circuit entre les bornes de référence 1, 2.

La bascule à retard représentée à la figure a une compacité optimale car elle utilise un nombre minimum de transistors à canal résistif qui sont des composants élémentaires encombrants en surface. En comparaison avec une bascule sans commande de réinitialisation, l'ajout de cette commande ne nécessite, dans l'exemple préféré, que deux transistors supplémentaires (les commutateurs 13 et 14) qui ne sont pas à canal résistif.

Bien qu'on ait décrit l'invention en référence à un exemple préféré, on comprendra que cet exemple n'est pas limitatif et que diverses variantes peuvent lui être apportées sans sortir du cadre de l'invention.

## Revendications

1. Bascule bistable , formant une bascule à retard, comprenant au moins une borne d'entrée (3) pour recevoir un signal d'entrée, une borne de sortie (4), une borne de commande de réinitialisation (5), un étage maître et un étage esclave,
- la borne d'entrée (3) étant reliée aux grilles de deux transistors à effet de champ de type respectivement P et N (11, 12) agencés pour former un signal d'écriture par inversion du signal d'entrée (D),
- l'étage maître comprenant une cellule de mémorisation (6), cette cellule de mémorisation (6) comprenant :
- un premier inverseur (7) ayant une entrée recevant le signal d'écriture et une sortie,
- un second inverseur (8) ayant une entrée reliée à la sortie du premier inverseur (7), et une sortie reliée à l'entrée du premier inverseur (7)
- la bascule comprenant en outre un premier et un deuxième transistors à effet de champ de types différents (14, 13), dont les grilles sont reliées à la borne de commande de réinitialisation, le canal du premier transistor (14) étant monté entre l'entrée du premier inverseur (7) et une première borne de référence (1), le canal du deuxième transistor (13) étant monté en série avec les canaux des deux transistors (11, 12) reliés à la borne d'entrée, la source du transistor de type P (11) relié à la borne d'entrée (3) étant reliée à la première borne de référence (1), et la source du transistor de type N (12) relié à la borne d'entrée ou la source du deuxième transistor (13) étant reliée à une seconde borne de référence (2),
caractérisée en ce que
- l'entrée du premier inverseur (7) est reliée à un premier interrupteur (10) commandé par des premiers signaux d'horloge (HM, NHM), ce premier interrupteur (10) étant placé entre le drain du transistor de type P (11) relié à la borne d'entrée (3) et l'entrée du premier inverseur (7),
- l'étage esclave (17) comprend
- une porte NON ET (18) ayant une première entrée reliée à la sortie du premier inverseur (7) par l'intermédiaire d'un second interrupteur (16) commandé par des seconds signaux d'horloge (HE, NHE) décalés temporellement par rapport aux premiers signaux d'horloge (HM, NHM), une seconde entrée reliée à la borne de commande de réinitialisation (5) et une sortie reliée à l'entrée d'un troisième inverseur (20), dont la sortie est reliée à la borne de sortie (4),
- un quatrième inverseur (19) ayant une entrée reliée à la sortie de la porte NON ET (18) et une sortie reliée à la première entrée de la porte NON ET (18).

## Patentansprüche

1. Bistabile Kippschaltung, die ein Laufzeitglied bildet und mindestens eine Eingangsklemme (3) zum Empfang eines Eingangssignals, eine Ausgangsklemme (4), eine Klemme zur Reinitialisierungssteuerung (5), eine Hauptstufe und eine Unterstufe aufweist, wobei die Eingangsklemme (3) mit den Gates von zwei Feldeffekttransistoren, einem P- und einem N-Transistor (11, 12), verbunden sind, die dazu vorgesehen sind, ein Schreibsignal durch Umkehrung des Eingangssignals (D) zu bilden, wobei die Hauptstufe aus einer Speicherzelle (6) besteht, und diese Speicherzelle (6) einen ersten Inverter (7) mit einem Eingang zum Empfang des Schreibsignals und einem Ausgang, einen zweiten Inverter (8) mit einem Eingang, der mit dem Ausgang des ersten Inverters (7) verbunden ist, und einem Ausgang, der mit dem Eingang des ersten Inverters (7) verbunden ist, umfaßt, wobei die Kippschaltung ferner einen ersten und einen zweiten Feldeffekttransistor unterschiedlicher Typen (14, 13) umfaßt, deren Gates mit der Klemme zur Reinitialisierungssteuerung verbunden sind, wobei der Kanal des ersten Transistors (14) zwischen den Eingang des ersten Inverters (7) und eine erste Referenzklemme (1) geschaltet ist, der Kanal des zweiten Transistors (13) in Reihe mit den Kanälen der beiden mit der Eingangsklemme verbundenen Transistoren (11, 12) geschaltet ist, die Quelle des mit der Eingangsklemme (3) verbundenen P-Transistors (11) mit der ersten Referenzklemme (1) verbunden ist, und die Quelle des mit der Eingangsklemme oder der Quelle des zweiten Transistors (13) verbundenen N-Transistors (12) mit einer zweiten Referenzklemme (2) verbunden ist,
dadurch gekennzeichnet, daß
- der Eingang des ersten Inverters (7) mit einem ersten Unterbrecher (10) verbunden ist, der durch erste Zeitgebersignale (HM, NHM) gesteuert wird, wobei dieser erste Unterbrecher (10) zwischen dem Drain des mit der Eingangsklemme (3) verbundenen P-Transistors (11) und dem Eingang des ersten Inverters (7) angeordnet ist,
- die Unterstufe (17) ein NICHT-UND-Glied (18) mit einem ersten Eingang, der mit dem Ausgang des ersten Inverters (7) über einen zweiten Unterbrecher (16) verbunden ist, der durch zweite Zeitgebersignale (HE, NHE) gesteuert wird, die gegenüber den ersten Zeitgebersignalen (HM, NHM) zeitlich verschoben sind, mit einem zweiten Eingang, der mit der Klemme zur Reinitialisierungssteuerung (5) verbunden ist, und mit einem Ausgang, der mit dem Eingang eines dritten Inverters (20) verbunden ist, dessen Ausgang mit der Ausgangsklemme (4) verbunden ist, aufweist, sowie einen vierten Inverter (19) mit einem Eingang, der mit dem Ausgang des NICHT-UND-Glieds (18) verbunden ist, und mit einem Ausgang, der mit dem ersten Eingang des NICHT-UND-Glieds (18) verbunden ist, aufweist.

## Claims

1. Flip-flop, forming a delay trigger circuit, comprising at least one input terminal (3) for receiving an input signal, an output terminal (4), a reinitialization control terminal (5), a master stage and a slave stage,
- the input terminal (3) being connected to the gates of two field-effect transistors respectively of the p and n type (11, 12), arranged to form a write signal by inverting the input signal (D),
- the master stage comprising a storage cell (6), this storage cell (6) comprising :
- a first inverter gate (7) having an input receiving the write signal and an output,
- a second inverter gate (8) having an input connected to the output of the first inverter gate (7) and an output connected to the input of the first inverter gate (7),
- the trigger circuit also comprising first and second field-effect transistors of different types (14, 13), the gates of which are connected to the reinitialization control terminal, the channel of the first transistor (14) being mounted between the input of the first inverter gate (7) and a first reference terminal (1), the channel of the second transistor (13) being mounted in series with the channels of the two transistors (11, 12) connected to the input terminal, the source of the p-type transistor (11) connected to the input terminal (3) being connected to the first reference terminal (1) and the source of the n-type transistor (12) connected to the input terminal or source of the second transistor (13) being connected to a second reference terminal (2),
characterized in that
- the input of the first inverter gate (7) is connected to a first switch (10) controlled by first clock signals (HM, NHM), this first switch (10) being positioned between the drain of the p-type transistor (11) connected to the input terminal (3) and the input of the first inverter gate (7),
- the slave stage (17) comprises
- a NAND gate (18) having a first input connected to the output of the first inverter gate (7) by the means of a second switch (16) controlled by second clock signals (HE, NHE) offset in time with respect to the first clock signals (HM, NHM), a second input connected to the reinitialization control terminal (5) and an output connected to the input of a third inverter gate (20), the output of which is connected to the output terminal (4),
- a fourth inverter gate (19) having an input connected to the output of the NAND gate (18) and an output connected to the first input of the NAND gate (18).
